# EUROPEAN PATENT APPLICATION

(11) **EP 0 690 579 A2**
(43) Date of publication of application: **03.01.1996**
(21) Application number: 95110151.8
(22) Date of filing: 29.06.1995
(51) Int. Cl.: H03K 19/173

(54) **Field programmable gate arrays**

(30) Priority: 30.06.1994 US 268469
(71) Applicant: TEXAS INSTRUMENTS INCORPORATED, Dallas Texas 75265 (US)
(72) Inventor: Krivacek, Paul D., Dallas, TX 75206 (US); Nasserbakht, Mitra (nmi), Dallas, TX 75225 (US); Mehendale, Mahesh M., Bangalore, India 56084 (IN); Harward, Mark G., Dallas, TX 75243 (US); Savithri, Nagaraj Narasimha, No. 60, 11th Main, Bangalore 560 070, Karnataka (IN); Sarathy, B.P. Vijaya, No. 488 (Ground Floor), Bangalore 560 082, Karnataka (IN)
(74) Representative: Schwepfinger, Karl-Heinz, Dipl.-Ing.

(57) **Abstract**

A flexible FPGA logic module circuit includes a first logic circuit (12) for receiving a first plurality of input signals (14) and generating a first logic output signal (36) in response to the first plurality of input signals (14). A second logic circuit (24) for receiving a second plurality of FPGA logic modules (26, 28, 30, 54) for receiving a second plurality of input signals (44, 46, 48, 50, 52, 56, 64, and 66) and generating a second logic output signal (62) in response to the second plurality of input signals (44, 46, 48, 50, 52, 56, 64, and 66). Control circuitry (18) associates the first logic circuit (12) and the second logic circuit (24) to receive a wide plurality of input signals (14, and 44, 46, 48, 50, 52, 56, 64, and 66). The first logic circuit (12) receives certain first ones (14) of said wide plurality of input signals and the second logic circuit (24) receives certain second ones of the wide plurality of input signals (44, 46, 48, 50, 52, 56, 64, and 66). The control circuitry (18) further associates the first logic circuit (12) and the second logic circuit (24) to produce a single logic output (62) from the wide plurality of input signals (14, and 44, 46, 48, 50, 52, 56, 64, and 66).

## Description

### TECHNICAL FIELD OF THE INVENTION

The present invention relates to electronic circuits and, more specifically, to a system of associated heterogeneous field programmable gate array (FPGA) logic modules that achieves improved performance and silicon area efficiency characteristics and methods for forming such a system.

### BACKGROUND OF THE INVENTION

Field programmable gate arrays (FPGAs) are integrated circuits that have two primary elements: (1) an array of logic modules and (2) a corresponding array of antifuses and wires for interconnections. The logic modules are made up of a number of fundamental devices such as transistors, diodes, resistors and the like. Logic modules can implement a plurality of digital logic functions depending on the states of the programmable elements associated with the logic modules. The selection of a logic module is a key design problem in the development of the overall FPGA architecture. Logic modules may be described by the number of signal inputs which they provide. Some logic modules provide a single output, while others provide more than a single output. A "wide" logic module provides more input signals than does a "narrow" logic module. The area required for each logic modules is a strong function of the number of logic module inputs. This leads to another descriptive term frequently used in the industry: logic module "granularity." A "fine-grained" FPGA architecture uses "narrow" logic modules. A "coarse-grained" architecture uses "wide" logic modules. A wide logic module typically possesses eight or more inputs.

The wide logic module can provide a performance advantage for many applications which require a relatively large number of related signals be operated on. The wider logic module may be able to perform the complete operation using a more shallow depth (as defined above) which reduces the number of logic module delays which has the additional benefit of avoiding signal propagation delays in the programmable interconnection system as signals are routed from one logic module to the next. The narrow logic module is typically more area efficient as it is easier for the mapping tools to decompose and map the user's design using small primitive logic elements than large primitive elements. The area efficiency of the narrow logic module typically provides a better usable gate density than do coarse logic modules. Although the delay through each narrow logic module may be slightly less than that of each wide logic module, the fine-grained FPGA typically requires a greater logic depth, which typically makes the fine-grain FPGA slower than the coarse-grain FPGA.

If a large class of commercial applications required a known width of input signals to be incident to logical blocks, the problem of the FPGA architect would be simplified. However, for generic digital logic the range of input signal width varies over a wide range from one input to more than eight.

The conflicting objectives of high performance and high usable gate density have led to compromises in previous FPGA implementations. Some attempts to overcome these problems include a hybrid of fine and coarse grain logic modules to alleviate the required tradeoffs. This solution is not presently practical due to the limited capabilities of the available software design tools as it greatly complicates the decomposition, mapping, placement, and routing tool tasks.

### SUMMARY OF THE INVENTION

There is a need for a flexible FPGA logic circuit that when necessary has the operational characteristics of a logic module circuit based on both wide logic modules and narrow logic modules.

There is a need for a flexible FPGA logic module circuit that can accommodate numerous combinations of inputs to selectively produce one or more logic outputs based on both wide and narrow sets of input signals.

There is yet a further need for a flexible FPGA logic module circuit that has improved FPGA circuit densities and performance and that efficiently implements random logic functions.

The present invention, accordingly, provides a flexible FPGA logic module with improved FPGA circuit densities and increased performance and that efficiently implements random logic functions to overcome limitations associated with known FPGA logic module circuits. The present invention provides a flexible FPGA logic module circuit that, at a minimum, provides two output modules that implement adders and data path elements efficiently while alternatively having the ability to appear as independent narrow modules or as a function of independent logic modules. Therefore, the flexible logic module circuit that the present invention provides is useful in reducing the module levels necessary to implement a given function, which improves performance while also being area efficient.

According to one aspect of the present invention, there is provided a flexible logic module circuit that includes a first logic circuit including a first plurality of FPGA logic modules for receiving a first plurality of input signals and generating a first logic output signal in response to the first plurality of input signals. A second logic circuit includes a second plurality of FPGA logic modules for receiving a second plurality of input signals and generating a second logic output signal in response to the second plurality of input signals. Control circuitry associates the first logic circuit and the second logic circuit to receive a wide plurality of input signals so that the first logic circuit receives certain ones of the wide plurality of input signals and the second logic circuit receives certain second ones of the wide plurality of input signals. The control circuitry further associates the first logic circuit and the second logic circuit to produce a single logic output from the wide plurality of input signals.

A technical advantage of the present invention is that it makes possible combining two or more different types of logic modules to responsively accommodate a narrow set of input signals or a wide set of input signals.

Another technical advantage of the present invention is that it minimizes wasted silicon area while also minimizing the time necessary to convert input signals to logic output signals.

Yet another technical advantage of the present invention is that it provides a flexible wide logic module circuit, in one embodiment, made of two or more modules that helps to eliminate silicon area waste that exists in known FPGA logic module circuits.

A further technical advantage of the present invention is that it eliminates the need for a unique wide module, if a unique wide module were added to a narrow module array. This simplifies mapping, placement, and routing issues required to support a dedicated wide module. This method also saves greatly on waste from wide module under-utilization. An example would be to implement a two-input AND gate, instead of an eight-input AND that the logic module may be capable of handling.

Yet a further technical advantage of the present invention is the silicon area improvement that it provides. For example, due to the extreme flexibility of the circuits that the present invention makes possible, less silicon area waste occurs.

### BRIEF DESCRIPTION OF THE DRAWINGS

The invention and its modes of use and advantages are best understood by reference to the following description of illustrative embodiments when read in conjunction with the accompanying drawings, wherein:
FIGURE 1 shows one embodiment of the present invention including modules denoted as types X, Y, and Z;
FIGURE 2 illustrates one example of the X module of the present embodiment;
FIGURE 3 shows one implementation of the Y module of the present embodiment; and
FIGURE 4 illustrates an alternative embodiment of the present invention that combines two narrow modules denoted as types A and B.

### DETAILED DESCRIPTION OF THE INVENTION

The illustrative embodiments of the present invention are best understood by referring to the FIGUREs wherein like numerals are used for like and corresponding parts of the various components.

The invention described herein is in the context of antifuse based FPGAs and which have the functionality defined by having selected logic module inputs connected to logical "one" (high) or logical "zero" (low). However, the concept of the invention should be clear to those skilled in the art as being applicable to FPGAs which use memory cells as the programmable storage element. The programmable storage elements such as antifuses and various types of memory cells (static access memory (SRAM), electrically programmable read only memory (EPROM), electrically erasable programmable read only memory (EEPROM), and FLASH erasable read only memory) are used to control the logical functionality of each logic module and the interconnection configuration.

The interconnect system includes a multitude of conductive wires which can be connected with other wires or to the inputs or outputs of logic modules. The programmable connections are implemented directly with antifuses. FPGAs which employ some type of memory cell implement the wiring connections through transistors or pass gates which are held in a conductive (on) state or in a non-conductive (off) state as determined by the state of the memory cell which stores one of two binary values. The system of interconnection includes of programmable connection elements and conductive wires which allow the connection of external signals from the IC bonding pads to the inputs of logic modules. The functionality of each logic module has been defined by programming the appropriate antifuse to connect the required logic module input pin to a logical one or zero. The remaining inputs are "signal inputs" onto which incident signals will be operated on by the function which the logic module implements. The result of this operation is provided at the output of the logic module. Note that this is occurring at a plurality of logic modules simultaneously as determined by the configuration of the entire FPGA array of logic modules and interconnection. The programmable interconnection system also provides for the connection of the logic module outputs to the inputs of other logic modules and IC output bonding pad drivers (to connect to the external world).

Thus, FPGAs allow the creation of various digital logic circuits. It is important to note that the overall function implemented by the FPGA is often composed of a plurality of complex functional blocks requiring numerous logic modules to be interconnected. These functional blocks can be partially described in terms of depth and width. The depth of a functional block built from numerous logic modules is measured in terms of the maximum number of logic modules which an incident input signal must reverse before reaching the output of the functional block. The width of a functional block is measured in terms of the number of incident input signals.

The FPGA architect strives to maximize performance by selecting the logic module with the goals of 1) minimizing the depth of the typical functional block, 2) minimizing the delay through each logic module, and 3) minimizing the delay caused by signal propagation through the programmable interconnect system by doing as much functionality as possible within the logic module. The architect must trade the performance goals off against the objective of providing the user with the maximum number of usable gates (digital logic functionality) within a given chip area (cost). A logic module designed solely to address the performance goals may provide so much internal functionality that the software design tools provided to the FPGA user may not efficiently utilize the logic modules. This is primarily determined by the "mapping" tool which decomposes the user's design into primitive operators which can be implemented by the logic module, then it matches, or maps, these operators onto the array of logic modules provided within the FPGA. If the mapping tool maps simple functions of few inputs onto complex logic modules which provide man inputs, few of the resources provided by the logic module will be utilized. This obviously will result in an overall poor usage of the FPGAs silicon area which will cause the chip cost to be high relative to the functionality which the user can obtain from the chip.

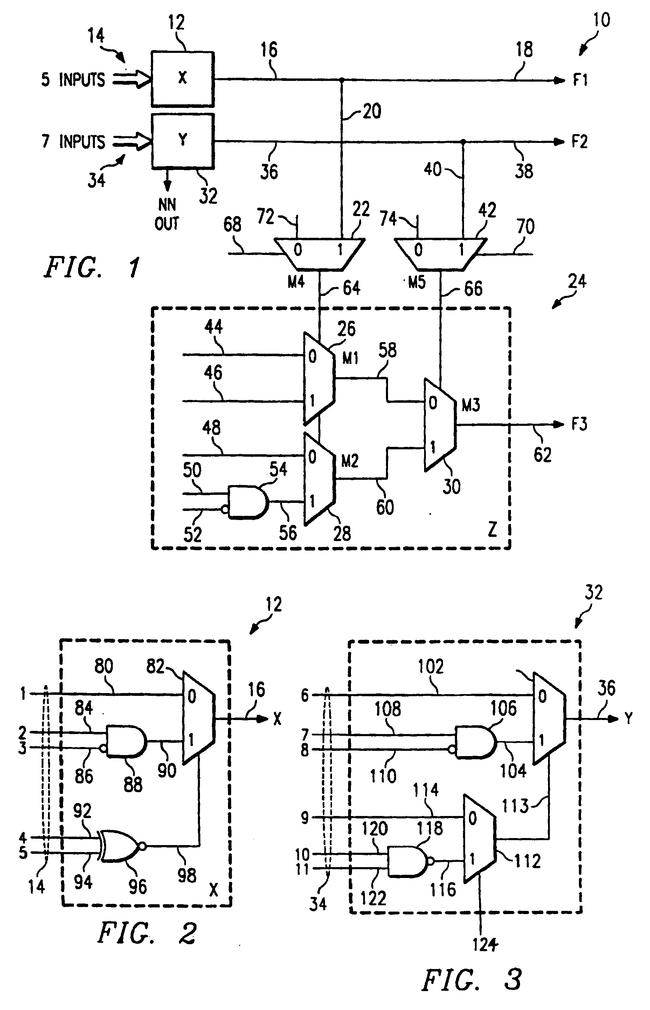

To understand how the present invention overcomes these and other limitations, reference is now made to FIGURE 1 in which appears flexible FPGA logic module circuit 10 that includes X module 12 that receives five input signals 14 for producing a first logic output signal 16. Logic output signal 16 is directed to F1 logic output 18 to input signal 20 incident on multiplexer 22. Multiplexer 22 may pass either input signal 20 or input signal 72 to Z logic circuit 24, depending on control signal 68. Logic circuit 24 is includes multiplexers 26, 28, and 30, and AND gate 54. In addition, Y logic circuit 32 receives seven inputs 34 to produce logic output signal 36. Logic output 36 may be either a separate F2 output 38 or an input signal 40 to two-to-one multiplexer 42.

Z logic circuit 24, as shown, may receive seven logic inputs. That is, Z logic circuit may receive input signal 44, input signal 46, input signal 48, input signal 50, and input signal 52. AND gate 54 receives input signal 50 and the logical inversion of input signal 52 to produce output signal 56. In Z logic circuit 24, M1 multiplexer 26 receives input signal 44 and input signal 46 and control signal 64 to produce output signal 58. M2 mutliplexer 28 produces output signal 60 from input signals 48 and 56 and control signal 64. Y logic circuit 32 has seven inputs and produces output signal 36 which is directed to output F2 signal 38 and to the input 40 of multiplexer 42. This signal can be input to Z logic circuit 24 if the control signal 70 for multiplexer 42 is a logical "one" value. Thus, multiplexers M1 and M2 can be controlled by the function implemented by X logic circuit 12. M3 multiplexer 30 can similarly be controlled by the output of the Y logic circuit 32. The skilled reader can discern that very wide functions of logic circuit X, Y, and Z can therefore be implemented with the composite logic module 10 of FIGURE 1.

Part of a wide set of input signals may simultaneously go from X logic circuit 12 into input signals 44, 46, 48, 50, and 52 of Z logic circuit 24 while the remaining part of the wide set of input signals, if of sufficient size, goes to X logic circuit 12 as one or more inputs 14 or to Y logic circuit 32 as one or more inputs 34 to produce a single F3 logic output 62. Five or fewer inputs of a narrow set of inputs may separately go to X logic circuit 12 to produce F1 output signal 18. Alternatively, seven or fewer inputs of a wide set of signal inputs may enter Y logic circuit 32 as one or more of input signals 34 to produce the single F2 logic output 38. Even further, as many as five inputs 14 may go to X logic circuit 12 and seven inputs 34 into Y logic circuit 32, while as many as seven inputs signals 44, 46, 48, 50, 52, 72 and 74 may go to Z logic circuit 24, i.e., a total of 19 inputs, to produce a single F3 logic output 62.

FIGURE 2 provides one possible implementation of X logic circuit 12 that produces logic output 16 from five input signals 14. For example, input signal 80 may go to multiplexer 82. Input signal 84 and the inversion of input signal 86 may go to AND gate 88 that produces a single intermediate signal 90 to multiplexer 82. In addition, input signal 92 and input signal 94 may go to NOR gate 96 that produces logic output 98 as an input to multiplexer 82. All of these signals may be used to produce logic output 16 from X logic circuit 12.

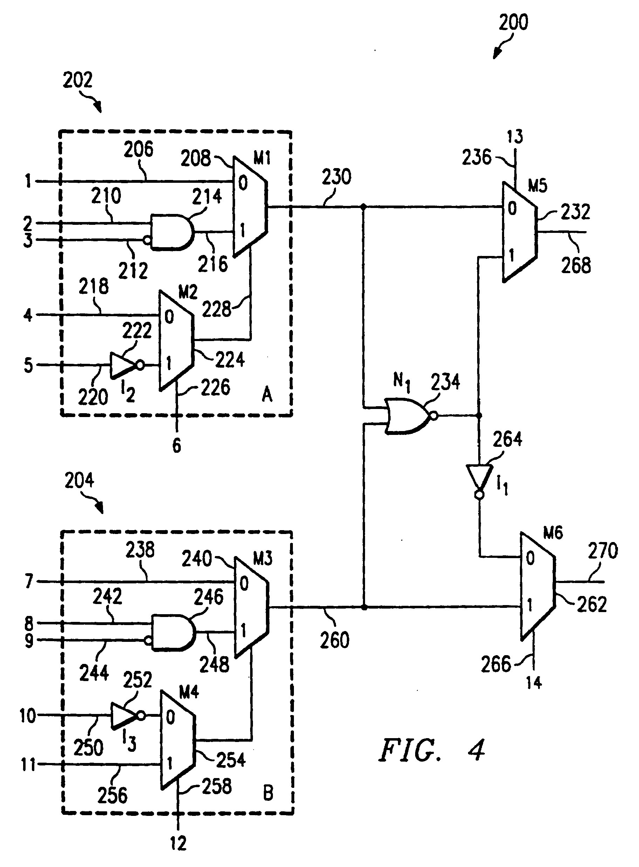

FIGURE 3 shows an exemplary implementation of Y logic circuit 32 that can receive seven input signals 34 to produce Y output logic signal 36. For example, multiplexer 100 may receive input 102 and input 104 from AND gate 106. AND gate 106 receives input signal 108 and the logical inversion of input signal 110. In addition, multiplexer 112 may receive input signal 114 and input signal 116 from NAND gate 118 to produce intermediate signal 113. NAND gate 118 receives input signal 120 and input signal 122. Multiplexer 112 also receives input 124.

Note that X logic circuit 12, Z logic circuit 24, and Y logic circuit 36 may each have slightly different functionality. For example, X logic circuit 12 may, instead of accommodating five input signals 14, accommodate fewer than five or more than five input signals. Likewise, Z logic circuit 24 and Y logic circuit 32 may each accommodate numbers of signal inputs numbers other than those that FIGUREs 1 through 3 indicate.

An important aspect of the present embodiment is that by controlling M4 multiplexer 18 and M5 multiplexer 42, it is possible to combine the logical outputs from either X logic circuit 12 or Y logic circuit 32 with the logic response that Z logic circuit 24 produces in response to input signals 44, 46, 48, 50, 52, 72, and 74 to produce a single F3 logic output 62. Alternatively and selectively, X logic circuit 12 may independently produce F1 logic output signal 18. Y logic circuit 32 may independently generate F2 logic output 38.

Flexible FPGA circuit 10 provides improved area efficiency, because it makes possible different combinations of input signals in the heterogenous logic circuits of X logic circuit 12, Z logic circuit 24, and Y logic circuit 32. This flexibility makes it possible to accommodate a much larger number of input signals with a minimal amount of additional circuit space. Moreover, the present embodiment takes advantage of the inventive concept of efficiently using logic modules. Because of this flexibility, narrow modules receive narrow functions, logic combination XZ or YZ, for example, may receive medium functions, and very wide modules may use the full XYZ combination.

In summary, the present embodiment provides a flexible FPGA logic module circuit that includes a first logic circuit having a first plurality of FPGA logic modules for receiving a first plurality of input signals and generating a first logic output signal in response to the first plurality of input signals. A second logic circuit includes a second plurality of FPGA logic modules for receiving a second plurality of input signals and generating a second logic output signal in response to the second plurality of input signals. Control circuitry associates with the first logic circuit and the second logic circuit to receive a wide plurality of input signals. Because of the control circuitry, the first logic circuit receives certain first ones of the wide plurality of input signals and the second logic circuit receives certain second ones of the wide plurality of the input signals. The control circuitry further associates the first logic circuit and the second logic circuit to produce a single logic output from the wide plurality of input signals.

There are any number of alternatives or changes in the design of flexible FPGA logic module circuit 10 that may be readily apparent to one of ordinary skill in the art. One example of an alternative embodiment appears in FIGURE 4. In FIGURE 4, alternative FPGA logic module circuit 200 includes logic module 202 having the designation of a type A logic module and logic module 204 having the designation of a type B logic module. Logic module 202 receives a first input via line 206 to M1 multiplexer 208. Also, a second input via line 210 and the inversion of a third input via line 212 go to AND gate 214. AND gate 214 presents an output via line 216 to multiplexer 208. In addition, a fourth input via line 218 and the inversion of fifth input via line 220 and I2 inverter 222 go to M2 multiplexer 224. M2 multiplexer 224 also receives a sixth input via line 226. From M2 multiplexer 224, output goes via line 228 to M1 multiplexer 208. M1 multiplexer 208 outputs via line 230 to M5 multiplexer 232 and N1 NOR gate 234. M5 multiplexer 232 also receives a thirteenth input via line 236.

Type B logic module 204 receives a seventh input via line 238 that goes directly to M3 multiplexer 240, while an eighth input via line 242 and the inversion of ninth input via line 244 go to AND gate 246. AND gate 246 presents to M3 multiplexer 240 an input via line 248. A tenth input passes along line 250 and I3 inverter 252 to M4 multiplexer 254. Also, M4 multiplexer 254 receives an eleventh input via line 256 and a twelfth input via line 258. Type B logic module 204 presents an output via line 260 that goes both to N1 NOR gate 234 and M6 multiplexer 262. M5 multiplexer 232 also receives output from N1 NOR gate 234, while M6 multiplexer 262 receives the inversion of output from M1 NOR gate 234 via I1 inverter 264. From line 266 M6 multiplexer 262 receives a fourteenth input. The result of these inputs are seen at M5 multiplexer 232 output 268 and M6 multiplexer 262 output 270.

The alternative embodiment of flexible FPGA logic module circuit 200, therefore, represents a combination of heterogeneous narrow logic modules of Type A and Type B. M5 multiplexer 232 and M6 multiplexer 262 operate as steering multiplexers to control whether Type A logic module 202 or Type B logic module 204 operate independently or operate as a wide combination of Type A logic module 202 together with Type B logic module 204. The larger combination will be an OR or NOR value of the output of N1 NOR gate 234 depending on whether the output goes to M6 multiplexer 262 or M5 multiplexer 232, respectively. But this is just one alternative embodiment.

There are many other ways to embody the present invention. Such alternatives may not be employed in the device of the preferred embodiment for any number of reasons, such as costs and performance considerations, size constraints, availability of materials, arbitrary design decisions, and the like. A number of these alternatives have been mentioned above. Thus, the present invention is intended to be limited only by the claims which are meant to cover such obvious alternatives and deviations from the preferred design.

## Claims

1. A flexible FPGA logic module circuit, comprising:
a first logic circuit receiving a first plurality of input signals and generating a first logic output signal in response to said first plurality of input signals;
a second logic circuit comprising a second plurality of FPGA logic modules for receiving a second plurality of input signals and generating a second logic output signal in response to said second plurality of input signals; and
control circuitry for associating said first logic circuit and said second logic circuit to receive a wide plurality of input signals such that said first logic circuit receives certain first ones of said wide plurality of input signals and said second logic circuit receive certain second ones of said wide plurality of input signals, said control circuitry further associating said first logic circuit and said second logic circuit to produce a single logic output from said wide plurality of input signals.

2. The flexible FPGA logic module circuit of Claim 1, further comprising:
a third logic circuit comprising a third plurality of FPGA logic modules for receiving a third party of input signals and generating therefrom a third logic output signal; and wherein
said control circuitry further comprising control circuitry for associating selectively and alternatively said first logic circuit and said third logic circuit as a first combination signal, and said second logic circuit and said third logic circuit as a second combination circuit, or said first logic circuit, said second logic circuit, and said third logic circuit as a third combination circuit in response to a wide plurality of input signals to generate a single logic output.

3. The flexible FPGA logic module circuit of Claim 1 or Claim 2, wherein said control circuitry further comprises input circuitry for separately receiving certain third ones of said wide plurality of input signals to said single logic output from said wide plurality of input signals.

4. The flexible FPGA logic module circuit of any preceding Claim, wherein said first logic circuit comprises a wide logic circuit for receiving a wide first plurality of input signals.

5. The flexible FPGA logic module circuit of Claim 4, wherein said second logic circuit comprises a narrow logic circuit for receiving a narrow second plurality of input signals.

6. The flexible FPGA logic module circuit of any of Claims 1 to 3, wherein said first logic circuit comprises a narrow logic circuit.

7. The flexible FPGA logic module circuit of any preceding Claim, wherein said control circuitry comprises multiplexer circuitry connected between said first logic circuit and said second logic circuits for selectively directing said first logic output signal as a direct output to external circuit or to said second logic circuit.

8. The flexible FPGA logic module of any preceding Claim, wherein said first logic circuit and said second logic circuits comprise functionally equivalent logic circuits for receiving equivalent numbers of inputs and producing an equivalent number of outputs.

9. A method for selectively associating a plurality of logic module circuits, for generating logic output signals in response to input signals of varying widths comprising the steps of:
generating a first logic output signal in response to the first plurality of input signals;
receiving a second plurality of input signals in a second logic circuit for generating a second logic output signal in response to the second plurality of input signals;
receiving a second plurality of input signals in a second logic circuit comprising a second plurality of FPGA logic modules;
generating a second logic output signal in response to the second plurality of input signals;
associating the first logic circuit and the second logic circuit to receive a wide plurality of input signals such that the first logic circuit receives certain first ones of the wide plurality of input signals and the second logic circuit receives certain second ones of the wide plurality of input signals; and
associating the first logic circuit and the second logic circuit to produce a single logic output from the wide plurality of input signals.

10. The method of Claim 9, further comprising the steps of:
receiving a third plurality of input signals in a third logic circuit generating therefrom a third logic output signal; and
associating selectively and alternatively the first logic circuit and the third logic circuit as a first combination signal, said second logic circuit and the third logic circuit as a second combination circuit, or the first logic circuit, the second logic circuit, and the third logic circuit as a third combination circuit in response to a wide plurality of input signals for generating a single logic output.

11. The method of Claim 9 or Claim 10, further comprising the step of separately receiving certain third ones of the wide plurality of input signals to the single logic output from the wide plurality of input signals.

12. The method of any of Claims 9 to 11, further comprising the step of receiving a wide first plurality of input signals in a wide logic circuit of the first logic circuit.

13. The method of Claim 12, further comprising the step of receiving a narrow second plurality of input signals in a narrow logic circuit of the second logic circuit.

14. The method of Claims 9 to 11, further comprising the step of receiving a narrow first plurality of input signals in the first logic circuit.

15. The method of any of Claims 9 to 14, further comprising the step of selectively directing the first logic output signal as a direct output to external circuitry or to the second logic circuit using multiplexer circuitry connected between the first logic circuit and the second logic circuit.

16. The method of any of Claims 9 to 15, further comprising the steps of receiving an equivalent number of inputs in the first logic circuit and the second logic circuit and generating an equivalent number of outputs from the first logic circuit and the second logic circuit by performing equivalent functions on the inputs.

17. A method for forming flexible FPGA logic module circuit comprising the steps of:
forming a first logic circuit for receiving a first plurality of input signals and generating a first logic output signal in response to the first plurality of input signals;
forming a second logic circuit for receiving a second plurality of FPGA logic modules for receiving a second plurality of input signals and generating a second logic output signal in response to the second plurality of input signals; and
forming control circuitry for associating the first logic circuit and the second logic circuit to receive a wide plurality of input signals such that the first logic circuit receives certain first ones of the wide plurality of input signals and the second logic circuit receive certain second ones of the wide plurality of input signals, the control circuitry further associating the first logic circuit and the second logic circuit to produce a single logic output from the wide plurality of input signals.
